(19)

Europäisches Patentamt
European Patent Office
Office européen des brevets

(11) **EP 2 712 090 A2**

(12) **EUROPEAN PATENT APPLICATION**

(43) Date of publication:
26.03.2014 Bulletin 2014/13

(51) Int Cl.:
**H03M 13/11** (2006.01)

(21) Application number: **13178269.0**

(22) Date of filing: **26.07.2013**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **22.09.2012 US 201213624927**

(71) Applicant: **LSI Corporation**
**Milpitas, CA 95035 (US)**

(72) Inventors:
• **Yang, Shaohua**
**San Jose, CA 95129 (US)**

• **Wang, Chung-Li**
**Milpitas, CA California 95035 (US)**
• **Liu, Dan**
**200030 Zhong Shan Nan (CN)**
• **Li, Zongwang**
**Milpitas, CA California 95035 (US)**

(74) Representative: **Ford, Esther Mary**
**Marks & Clerk LLP**
**62-68 Hills Road**
**Cambridge CB2 1LA (GB)**

(54) **Iterative detection and LDPC decoding with full and fractional local iterations**

(57) Embodiments of the present invention are related to systems and methods for an LDPC decoder with fractional local iterations that may be used in a data processing system with an LDPC decoder and data detector to better balance processing times in the LDPC decoder and data detector.

FIG. 2

EP 2 712 090 A2

**Description**

BACKGROUND

Various data processing systems have been developed including storage systems, cellular telephone systems, and radio transmission systems. In such systems data is transferred from a sender to a receiver via some medium. For example, in a storage system, data is sent from a sender (i.e., a write function) to a receiver (i.e., a read function) via a storage medium. As information is stored and transmitted in the form of digital data, errors are introduced that, if not corrected, can corrupt the data and render the information unusable. The effectiveness of any transfer is impacted by any losses in data caused by various factors. Many types of error checking systems have been developed to detect and correct errors in digital data. For example, in perhaps the simplest system, a parity bit can be added to a group of data bits, ensuring that the group of data bits (including the parity bit) has either an even or odd number of ones. When using odd parity, as the data is prepared for storage or transmission, the number of data bits in the group that are set to one are counted, and if there is an even number of ones in the group, the parity bit is set to one to ensure that the group has an odd number of ones. If there is an odd number of ones in the group, the parity bit is set to zero to ensure that the group has an odd number of ones. After the data is retrieved from storage or received from transmission, the parity can again be checked, and if the group has an even parity, at least one error has been introduced in the data. At this simplistic level, some errors can be detected but not corrected.

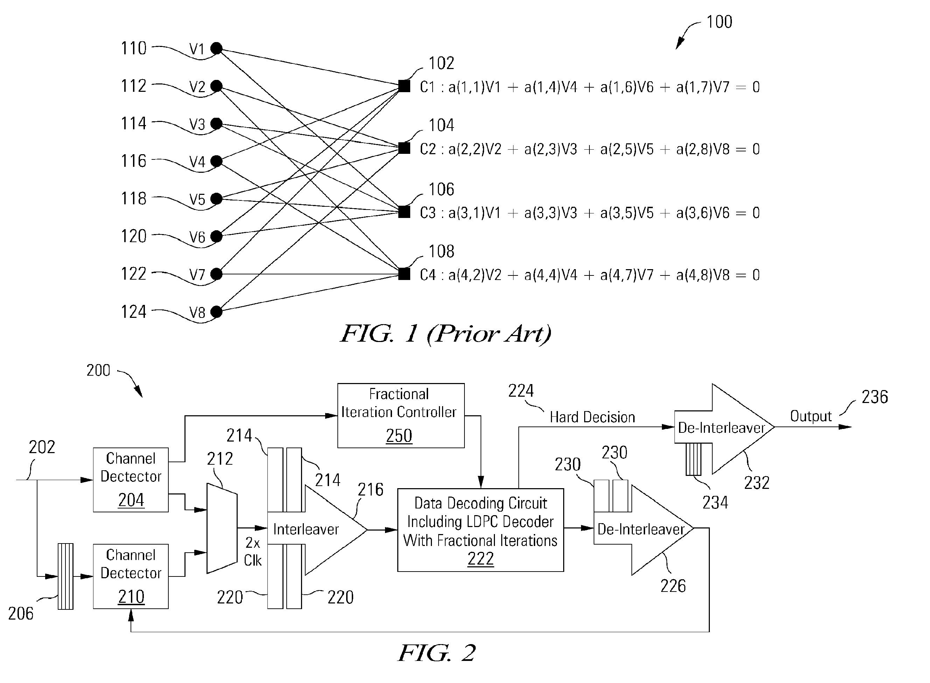

The parity bit may also be used in error correction systems, including in Low Density Parity Check (LDPC) decoders. An LDPC code is a parity-based code that can be visually represented in a Tanner graph 100 as illustrated in Fig. 1. In an LDPC decoder, multiple parity checks are performed in a number of check nodes 102, 104, 106 and 108 for a group of variable nodes 110, 112, 114, 116, 118, 120, 122, and 124. The connections (or edges) between variable nodes 110-124 and check nodes 102-108 are selected as the LDPC code is designed, balancing the strength of the code against the complexity of the decoder required to execute the LDPC code as data is obtained. The number and placement of parity bits in the group are selected as the LDPC code is designed. Messages are passed between connected variable nodes 110-124 and check nodes 102-108 in an iterative process, passing beliefs about the values that should appear in variable nodes 110-124 to connected check nodes 102-108. Parity checks are performed in the check nodes 102-108 based on the messages and the results are returned to connected variable nodes 110-124 to update the beliefs if necessary. LDPC decoders may be implemented in binary or non-binary fashion. In a binary LDPC decoder, variable nodes 110-124 contain scalar values based on a group of data and parity bits that are retrieved from a storage device, received by a transmission system or obtained in some other way. Messages in the binary LDPC decoders are scalar values transmitted as plain-likelihood probability values or log-likelihood-ratio (LLR) values representing the probability that the sending variable node contains a particular value. In a non-binary LDPC decoder, variable nodes 110-124 contain symbols from a Galois Field, a finite field $GF(p^k)$ that contains a finite number of elements, characterized by size $p^k$ where p is a prime number and k is a positive integer. Messages in the non-binary LDPC decoders are multidimensional vectors, generally either plain-likelihood probability vectors or LLR vectors.

The connections between variable nodes 110-124 and check nodes 102-108 may be presented in matrix form as follows, where columns represent variable nodes, rows represent check nodes, and a random non-zero element $a(i,j)$ from the Galois Field at the intersection of a variable node column and a check node row indicates a connection between that variable node and check node and provides a permutation for messages between that variable node and check node:

$$H = \begin{bmatrix} a(1,1) & 0 & 0 & a(1,4) & 0 & a(1,6) & a(1,7) & 0 \\ 0 & a(2,2) & a(2,3) & 0 & a(2,5) & 0 & 0 & a(2,8) \\ a(3,1) & 0 & a(3,3) & 0 & a(3,5) & a(3,6) & 0 & 0 \\ 0 & a(4,2) & 0 & a(4,4) & 0 & 0 & a(4,7) & a(4,8) \end{bmatrix}$$

By providing multiple check nodes 102-108 for the group of variable nodes 110-124, redundancy in error checking is provided, enabling errors to be corrected as well as detected. Each check node 102-108 performs a parity check on bits or symbols passed as messages from its neighboring (or connected) variable nodes. In the example LDPC code corresponding to the Tanner graph 100 of Fig. 1, check node 102 checks the parity of variable nodes 110, 116, 120 and 122. Values are passed back and forth between connected variable nodes 110-124 and check nodes 102-108 in an iterative process until the LDPC code converges on a value for the group of data and parity bits in the variable nodes 110-124. For example, variable node 110 passes messages to check nodes 102 and 106. Check node 102 passes messages back to variable nodes 110, 116, 120 and 122. The messages between variable nodes 110-124 and check nodes 102-108 are probabilities or beliefs, thus the LDPC decoding algorithm is also referred to as a belief propagation algorithm. Each message from a node represents the probability that a bit or symbol has a certain value based on the current value of the node and on previous messages to the node.

A message from a variable node to any particular neighboring check node is computed using any of a number of algorithms based on the current value of the variable node and the last messages to the variable node from neighboring check nodes, except that the last message from that particular check node is omitted from the calculation to prevent positive feedback. Similarly, a message from a check node to any particular neighboring variable node is computed based on the current value of the check node and the last messages to the check node from neighboring variable nodes, except that the last message from that particular variable node is omitted from the calculation to prevent positive feedback. As local decoding iterations are performed in the system, messages pass back and forth between variable nodes 110-124 and check nodes 102-108, with the values in the nodes 102-124 being adjusted based on the messages that are passed, until the values converge and stop changing or until processing is halted.

In a data processing system with a data detector such as a Viterbi detector and an LDPC decoder, either the detector or decoder may take longer processing a block of data, leading to delays in one of them while waiting for the other to complete processing.

BRIEF SUMMARY

According to a first aspect of the present invention, there is provided an apparatus for processing data comprising: a data detector operable to detect data values in a data set; and a low density parity check decoder operable to iteratively perform a plurality of decoding iterations on the data set, wherein the plurality of decoding iterations comprises a selection of full decoding iterations and fractional decoding iterations to balance a decoder processing time with a detector processing time.

There may further be provided the apparatus, wherein the low density parity check decoder is operable to determine a number of the full decoding iterations and a number of the fractional decoding iterations that can be included in the selection of full decoding iterations and fractional decoding iterations without the decoder processing time exceeding the detector processing time. In such an apparatus, the low density parity check decoder may be operable to include as many as possible of the full decoding iterations and of the fractional decoding iterations in the selection of full decoding iterations and fractional decoding iterations without the decoder processing time exceeding the detector processing time.

There may further be provided the apparatus, further comprising a fractional iteration controller operable to communicate the detector processing time from the data detector to the low density parity check decoder.

There may further be provided the apparatus,, wherein the data detector comprises a soft output Viterbi algorithm detector.

There may still further be provided the apparatus, wherein the decoder processing time and the detector processing time are balanced for a same data set.

There may further be provided the apparatus, wherein the decoder processing time and the detector processing time are balanced for different data sets that are concurrently processed in the data detector and the low density parity check decoder.

There may further be provided the apparatus, wherein the low density parity check decoder comprises a non-layer decoder, and wherein the fractional decoding iterations comprise a local decoding iteration in which a subset of a plurality of columns in an H matrix for the non-layer decoder are processed during the local decoding iteration.

There may further be provided the apparatus, wherein the low density parity check decoder comprises a layer decoder, and wherein the fractional decoding iterations comprise a local decoding iteration in which a subset of a plurality of layers in an H matrix for the layer decoder are processed during the local decoding iteration.

There may yet further be provided the apparatus, wherein the low density parity check decoder is operable to generate check node to variable node messages in one of the fractional decoding iterations based on a combination of new data generated in said one of the fractional decoding iterations and old data generated in one of the full decoding iterations.

There may further be provided the apparatus, wherein the apparatus is implemented as an integrated circuit.

There may still further be provided the apparatus, wherein the apparatus is incorporated in a storage device. The storage device may comprise a redundant array of independent disks.

There may further be provided the apparatus, wherein the apparatus is incorporated in a transmission system.

According to a second aspect of the present invention, there is provided a method for processing data comprising: detecting data values of a data set in a data detector; determining a detector processing time for the data set in the data detector; and performing a plurality of local decoding iterations on the data set in a low density parity check decoder, wherein the plurality of local decoding iterations comprises a selection of full decoding iterations and fractional decoding iterations to balance a decoder processing time with the detector processing time.

There may further be provided the method, further comprising including as many as possible of the full decoding iterations and the fractional decoding iterations in the plurality of local decoding iterations without the decoder processing time exceeding the detector processing time. The low density parity check decoder may comprise a non-layer decoder, wherein performing one of the fractional decoding iterations comprises processing a subset of a plurality of columns in an H matrix for the non-layer decoder during the local decoding iteration. Alternatively, the low density parity check decoder may comprise a layer decoder, wherein performing one of the fractional decoding iterations comprises processing a subset of a plurality of layers in an H matrix for the layer decoder during the local decoding iteration.

There may further be provided the method, wherein performing one of the fractional decoding iterations comprises generating check node to variable node messages in said one of the fractional decoding iterations based on a combination of new data generated in said one of the fractional decoding iterations and old data generated in one of the full decoding iterations.

According to a third aspect of the present invention, there is provided a storage system comprising: a storage medium maintaining a data set; a read/write head assembly operable to sense the data set on the storage medium; and an apparatus for processing the data set comprising: a data detector operable to detect data values in the data set; and a low density parity check decoder operable to iteratively perform a plurality of decoding iterations on the data set, wherein the plurality of decoding iterations comprises a selection of full decoding iterations and fractional decoding iterations to balance a decoder processing time with a detector processing time.

BRIEF DESCRIPTION OF THE DRAWINGS

A further understanding of the various embodiments of the present invention may be realized by reference to the figures which are described in remaining portions of the specification. In the figures, like reference numerals are used throughout several figures to refer to similar components. In some instances, a sub-label consisting of a lower case letter is associated with a reference numeral to denote one of multiple similar components. When reference is made to a reference numeral without specification to an existing sub-label, it is intended to refer to all such multiple similar components.

Fig. 1 depicts a Tanner graph of an example prior art LDPC code;

Fig. 2 depicts a data detection and decoding circuit with an LDPC decoder with fractional local iterations in accordance with some embodiments of the present invention;

Fig. 3A depicts the interleaved detecting and decoding of two data sectors, with processing time wasted in the LDPC decoder while waiting for the detector to complete processing in accordance with some embodiments of the present invention;

Fig. 3B depicts the interleaved detecting and decoding of two data sectors, with fractional local iterations performed in the LDPC decoder to balance the processing time in the detector and LDPC decoder in accordance with some embodiments of the present invention;

Fig. 4 depicts a diagram illustrating the division of an H matrix to enable fractional local iterations in a non-layer LDPC decoder in accordance with some embodiments of the present invention;

Fig. 5 depicts a block diagram of a non-layer LDPC decoder with fractional local iterations in accordance with some embodiments of the present invention;

Fig. 6A depicts a diagram illustrating layered decoding with a three-layer H matrix in an LDPC layer decoder with fractional local iterations disabled in accordance with some embodiments of the present invention;

Fig. 6B depicts a diagram illustrating layered decoding with a three-layer H matrix in an LDPC layer decoder with fractional local iterations enabled to skip the first two layers in the first local iteration in accordance with some embodiments of the present invention;

Fig. 7 depicts a block diagram of an LDPC layer decoder with fractional local iterations in accordance with some embodiments of the present invention;

Fig. 8 depicts a flow diagram of a data detection and decoding operation with an LDPC decoder with fractional local iterations in accordance with some embodiments of the present invention;

Fig. 9 depicts a storage system including a data processing circuit with an LDPC decoder with fractional local iterations in accordance with some embodiments of the present invention; and

Fig. 10 depicts a wireless communication system including a data processing circuit with an LDPC decoder with fractional local iterations in accordance with some embodiments of the present invention.

DETAILED DESCRIPTION OF THE INVENTION

Embodiments are related to systems and methods for an LDPC decoder with fractional local iterations that may be used, for example, in a data processing system with an LDPC decoder and data detector to better balance processing times in the LDPC decoder and data detector. By dividing local decoding iterations into two or more segments, partial or fractional decoding iterations may be performed during a global iteration to more closely balance the processing time of the LDPC decoder and the data detector. In some embodiments, the processing time for a data sector in the data detector is determined, and the LDPC decoder determines the number of full and fractional local decoding iterations to perform based on the data detector processing time. In some embodiments, the LDPC decoder fills the available processing time for a data sector as fully as possible, performing full and fractional local decoding iterations as long as possible without exceeding the processing time in the data detector for the same data sector. Local decoding iterations may be divided by dividing the H matrix for the codeword into two or more segments. The H matrix may be divided into segments of equal size, or of different sizes to provide finer control over the processing time in the LDPC decoder. The LDPC decoder may be a layered decoder or a non-layered decoder. In some layered decoder embodiments, the H matrix may be divided by rows, with a fractional iteration processing a subset of the rows in a layer. In some non-layered decoder embodiments, the H matrix may be divided by columns, with a fractional iteration processing a subset of the columns in the H matrix.

The above provides only a general outline of some embodiments according to the present invention. Many other objects, features, advantages and other embodiments of the present invention will become more fully apparent from the following detailed description, the appended claims and the accompanying drawings.

As mentioned above, embodiments are related to systems and methods for an LDPC decoder with fractional local iterations that may be used, for example, in a data processing system with an LDPC decoder and data detector to better balance processing times in the LDPC decoder and data detector. The LDPC decoder used in various embodiments may be any type of LDPC decoder, including binary and non-binary, layered and non-layered, and using any suitable decoding algorithm. LDPC technology is applicable to transmission of information over virtually any channel or storage of information on virtually any media. Transmission applications include, but are not limited to, optical fiber, radio frequency channels, wired or wireless local area networks, digital subscriber line technologies, wireless cellular, Ethernet over any medium such as copper or optical fiber, cable channels such as cable television, and Earth-satellite communications. Storage applications include, but are not limited to, hard disk drives, compact disks, digital video disks, magnetic tapes and memory devices such as DRAM, NAND flash, NOR flash, other non-volatile memories and solid state drives.

By dividing local decoding iterations into two or more segments, partial or fractional decoding iterations may be performed during a global iteration to more closely balance the processing time of the LDPC decoder and the data detector. In some embodiments, the processing time for a data sector in the data detector is determined, and the LDPC decoder determines the number of full and fractional local decoding iterations to perform based on the data detector processing time. In some embodiments, the LDPC decoder fills the available processing time for a data sector as fully as possible, performing full and fractional local decoding iterations as long as possible without exceeding the processing time in the data detector for the same data sector. Local decoding iterations may be divided by dividing the H matrix for the codeword into two or more segments. The H matrix may be divided into segments of equal size, or of different sizes to provide finer control over the processing time in the LDPC decoder. The LDPC decoder may be a layered decoder or a non-layered decoder. In some layered decoder embodiments, the H matrix may be divided by rows, with a fractional iteration processing a subset of the rows in a layer. In some non-layered decoder embodiments, the H matrix may be divided by columns, with a fractional iteration processing a subset of the columns in the H matrix.

Turning to Fig. 2, one implementation of a data decoding circuit 200 that may include an LDPC decoder with fractional local iterations 222 is disclosed in accordance with some embodiments of the present invention. Data decoding circuit 200 includes a data input 202 that is fed to a channel detector 204. In some embodiments, data input 202 is a digital data stream, for example containing digitized and equalized data read from a magnetic storage device. Channel detector 204 may be any type of channel detector known in the art including, but not limited to, a soft output Viterbi algorithm detector (SOVA) or a maximum a posteriori (MAP) detector. Based on the disclosure provided herein, one of ordinary skill in the art will recognize a variety of channel detectors that may be used in accordance with different embodiments of the present invention. In addition, data input 202 is provided to an input data buffer 206 that is designed to hold a number of data sets received from data input 202. The size of input data buffer 206 may be selected to provide sufficient buffering such that a data set input via data input 202 remains available at least until a first iteration processing of that same data set is complete and the processed data is available in a ping pong buffer 230 (i.e., a queuing buffer) as more fully described below. Input data buffer 206 provides the data sets to a channel detector 210. Similar to channel detector 204, channel detector 210 may be any type of channel detector known in the art including, but not limited to, a SOVA detector or a MAP detector. Again, based on the disclosure provided herein, one of ordinary skill in the art will recognize a variety of channel detectors that may be used in accordance with different embodiments of the present invention.

The output of both channel detector 204 and channel detector 210 are provided to an interleaver circuit 216 via a multiplexer 212. Such outputs may be, for example, log likelihood ratio (LLR) values. Interleaver circuit 216 interleaves the output of channel detector 204 and separately interleaves the output of channel detector 210 using two ping pong buffers 214, 220. One of the buffers in ping pong buffer 214 holds the result of a prior interleaving process of the output from channel detector 204 and is unloaded to LDPC decoder with fractional local iterations 222, while the other buffer of ping pong buffer 214 holds a data set from channel detector 204 that is currently being interleaved. Similarly, one of the buffers in ping pong buffer 220 holds the result of a prior interleaving process of the output from channel detector 210 and is unloaded to LDPC decoder 222, while the other buffer of ping pong buffer 220 holds a data set from channel detector 210 that is currently being interleaved.

In normal operation, a first data set is introduced via data input 202 to channel detector 204. Channel detector 204 performs its channel detection algorithm and provides both a hard output and a soft output to multiplexer 212. The hard and soft decision data is written to one buffer of ping pong buffer 214. The processing time in the channel detector 204 for the data set is determined and provided to the LDPC decoder 222. The detector processing time provides an indication of the duration of processing for the data set, and may be measured in clock cycles or other units of measurement, or may be a relative measurement based on based on the processing time for a standard data set. At the same time the detector output is written into the buffer, interleaver 216 interleaves the data set by writing consecutive data into non-consecutive memory/buffer addresses based on the interleaver algorithm/mapping. Once interleaver 216 completes its interleaving process, the interleaved data is decoded by LDPC decoder 222.

The LDPC decoder 222 performs a mixture of full and partial or fractional decoding iterations as appropriate to fill the available processing time so that the LDPC decoder 222 is not waiting idle for the channel detector 204 to complete processing, but without exceeding the detector processing time so that the channel detector 204 would be waiting for the LDPC decoder 222 to complete processing. The decoding time may be adjusted in the LDPC decoder 222 based on the processing time for the same data set when it is processed in the channel detector 204, or may be based on the processing time for the data set currently being processed in the channel detector 204 or in channel detector 210, or both, for example attempting to match the longer processing time of the two detectors 204 and 210. A fractional iteration controller 250 may be provided in some embodiments to pass information regarding the processing time in the channel detector 204 and/or channel detector 210 to the LDPC decoder 222, and in some cases to assist in determining the processing time. In some embodiments, the fractional iteration controller 250 also assists in allocating decoding resources LDPC decoder 222 such as the number of full and fractional iterations to perform based on the processing time in the channel detector 204.

Where the data converges, LDPC decoder 222 writes its output as hard decision output 224 to output data buffer 234 and the processing is completed for that particular data set. Alternatively, where the data does not converge, LDPC decoder 222 writes its output (both soft and hard) to ping pong buffer 230.

The data written to ping pong buffer 230 is fed back to channel detector 210. Channel detector 210 selects the data set that corresponds to the output in ping pong buffer 230 from input data buffer 206 and performs a subsequent data detection aided by the soft output data generated by LDPC decoder 222 fed back from ping pong buffer 230. By using the previously generated soft data for data maintained in input data buffer 206, channel detector 210 generally performs a subsequent channel detection with heightened accuracy. The output of this subsequent channel detection is passed to interleaver 216 via multiplexer 212. The data is written to one buffer of ping pong buffer 220, and interleaver 216 interleaves the data. The interleaved data is then passed to LDPC decoder 222 where it is decoded a second time. Similar to the first iteration, a decision is made as to whether the data converged or whether there is insufficient space in ping pong buffer 230 to handle the data. Where such is the case, LDPC decoder 222 writes its output as hard decision output 224 to output data buffer 234 and the processing is complete for that particular data set. Alternatively, where the data does not converge and there is sufficient buffer space in ping pong buffer 230 to receive an additional data set, LDPC decoder 222 writes its output (both soft and hard) to ping pong buffer 230 where it is passed back to channel detector 210 for a third pass. Sufficient space is defined in ping pong buffer 230 by having at least reserved space for the data set from the first detector and decoder iteration after the data set from the second detector and decoder iteration is written into the ping pong buffer 230. Notably, in some embodiments, one or more of ping pong buffers 214, 220, 230 may be omitted, with the data set being passed directly between components due to the improved matching of processing time.

It should be noted that, as an example, a first data set may be applied at data input 202 and that it takes a number of iterations to converge while all subsequent data sets applied at data input 202 converge on the first pass (i.e., on a single iteration). In such a case, the first data set may be processed a number of times (i.e., a number of global iterations) that is limited by the amount of memory available in output data buffer 234. Once output data buffer 234 is full or once an ordered set of outputs are available, the most recent hard decision output corresponding to the first data set is provided as a hard decision output and de-interleaver 234 re-orders the outputs putting the first output in the first position. With this done, output data buffer 234 is flushed out as output 236.

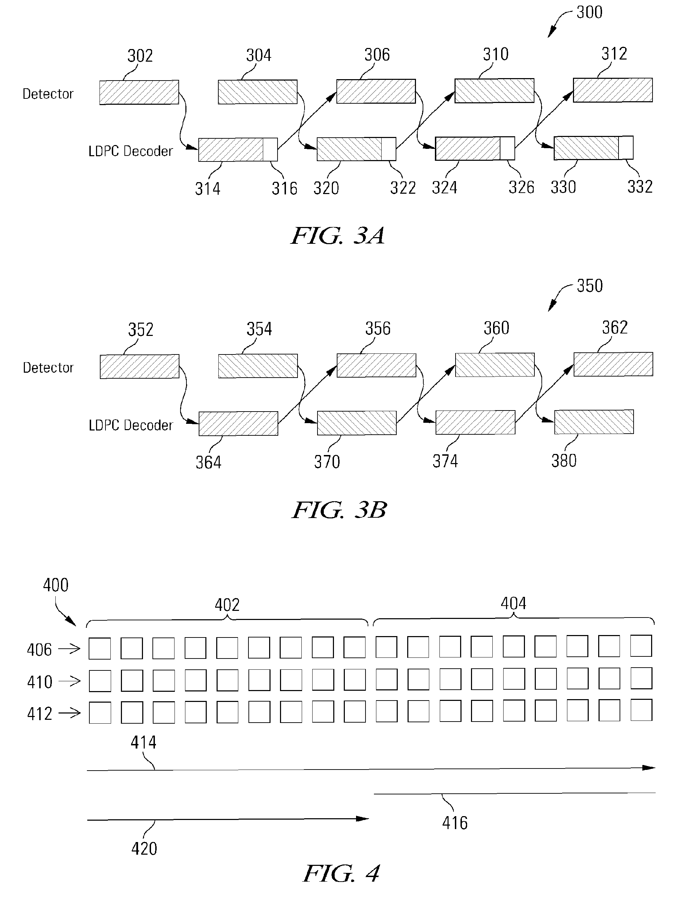

The alternating detecting and decoding of two data sets is depicted in the diagram 300 of Fig. 3A as it may proceed in the data decoding circuit 200 without fractional local iterations. The two data sets are distinguished in diagram 300 by different cross-hatch orientations. Each block in diagram 300 represents a time slot for processing a data set. The diagram 300 is intended to graphically show the ping-pong nature of the processing, and not to accurately depict the timing relationship between processing time slots in the channel detector 204 and LDPC decoder 222 or between successive processing time slots in either the channel detector 204 or LDPC decoder 222. The detector processing time granularity is based on data sets or sectors. In other words, the channel detector 204 processes one entire data set each time slot. The decoder processing time is based on local decoding iterations, with an example LDPC decoder 222 performing multiple local decoding iterations per processing time slot. In some embodiments, the data decoding circuit 200 is a client-server codec system, where the channel detector 204 and LDPC decoder 222 process data sets sequentially in ping-pong fashion. The channel detector 204 and LDPC decoder 222 may have different processing times due to different code rate options, decoder scheduling, user data length in a data sector, etc. If the processing time in the LDPC decoder 222 is shorter than in the channel detector 204, the LDPC decoder 222 waits for the output from the channel detector 204.

The first data set is processed in the channel detector 204 at time slot 302, and is then decoded in LDPC decoder 222 at time slot 314. The processing of a data set in the channel detector 204 and then the LDPC decoder 222 represents a single global iteration. The repeated processing of a data set internally in the LDPC decoder 222 is a local iteration or local decoding iteration. When the LDPC decoder 222 performs only full local decoding iterations, it may have a wait time 316 after completing the last full local decoding iteration before it can begin processing the next data set from the channel detector 204. Once the first data set is completed in the channel detector 204 during time slot 302, the second data set is processed in the channel detector 204 at time slot 304, and is then decoded in LDPC decoder 222 at time slot 320. The alternating or ping-pong processing of data sets continues until data has converged for a data set or until the maximum allowable number of global iterations has been completed for a data set, after which it is kicked out of the data decoding circuit 200 to make way for a new data set. The first data set may thus be processed in the channel detector 204 and LDPC decoder 222 at time slots 302, 314, 306, 324 and 312. The second data set may be processed in the channel detector 204 and LDPC decoder 222 at time slots 304, 320, 310 and 330. At each time slot 314, 320, 324, 330 in the LDPC decoder 222, the LDPC decoder 222 may have an inactive waiting period 316, 322, 326, 332 after completing the last possible full decoding iteration until the data is available from the channel detector 204 to begin the next global iteration in the LDPC decoder 222.

Adding an additional full local decoding iteration in the LDPC decoder 222 in an attempt to fill the waiting periods 316, 322, 326, 332 will make the processing time, or duration of a time slot, in the LDPC decoder 222 exceed the processing time, or duration of a time slot, of the channel detector 204. If the processing time in the LDPC decoder 222 exceeds that in the channel detector 204, overall latency in the system is increased. By performing fractional local iterations in the LDPC decoder 222, the waiting periods 316, 322, 326, 332 can be occupied by further decoding without exceeding the processing time in the channel detector 204. The fractional local decoding iterations take less time than a full local decoding iteration, and thus may be fit into the waiting periods 316, 322, 326, 332. These additional local decoding iterations improve decoding performance and thus overall performance of the data decoding circuit 200.

As shown in diagram 350 in Fig. 3B, waiting periods in the LDPC decoder 222 may be substantially eliminated by adding fractional local decoding iterations. The first data set may be processed in the channel detector 204 and LDPC decoder 222 at time slots 352, 364, 356, 374 and 362. The second data set may be processed in the channel detector 204 and LDPC decoder 222 at time slots 354, 370, 360 and 380. The actual processing time in the channel detector 204 and LDPC decoder 222 is substantially matched using fractional local decoding iterations to reduce or eliminate waiting periods in the LDPC decoder 222.

Turning to Fig. 4, the division of an H matrix 400 into segments to enable fractional local iterations in a non-layer LDPC decoder is depicted in accordance with some embodiments of the present invention. In this example, the H matrix 400 is divided into two equal-sized segments, a left side 402 and a right side 404. In other embodiments, the H matrix 400 may be divided by column into more than two segments, or into segments of unequal sizes. In the non-layer LDPC decoder, the H matrix 400 is processed row by row, column by column. A full local decoding iteration processes both sides 402 and 404, either from a single row or word, for example processing all columns of row 406, or spanning two rows, for example processing the right side 404 of row 410 and the left side 402 of row 412 during one iteration. The global decoding iteration in the non-layer LDPC decoder may begin at the top left circulant of the H matrix 400 in the left side 402 of the first row 406, or may begin at any other row and on the right side 404 instead of the left side 402. The fractional iterations may thus be performed at the beginning, middle or end of a global decoding iteration in the non-layer LDPC decoder. A fractional iteration can thus be achieved by terminating the decoding after processing only one side 402 or 404 of the H matrix 400, beginning either at the left side 402 or the right side 404.

After processing two half sections, either from a single row (e.g., 406) or spanning two rows (e.g., 410 and 412), the C2V message for the row may be generated based on the V2C message content for the two half sections, completing a local iteration. In some embodiments, after the first local iteration in which the entire H matrix 400 has been processed, the C2V messages may be updated after every half-row by combining the current data from the most recent half-row processed with older data from the half-row processed before the most recent. Data for the left side 402 and right side 404 used to update C2V messages may thus include both current and old data.

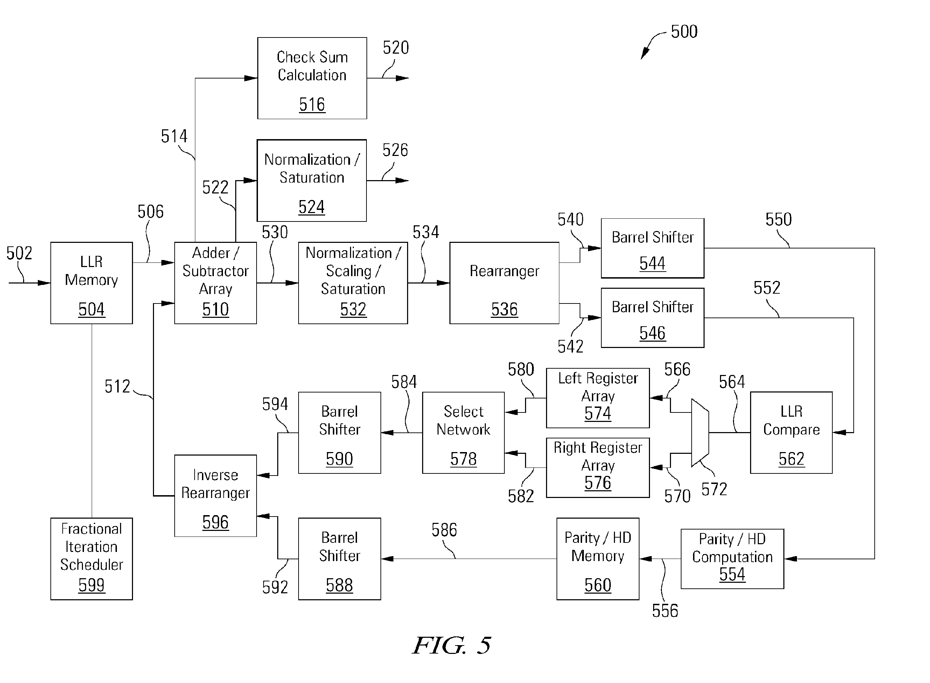

Turning to Fig. 5, an example non-layer LDPC decoder 500, in this example a non-binary decoder, is shown in accordance with various embodiments of the present invention, applying a simplified min-sum based decoding algorithm. Again, it is important to note that the LDPC decoder with fractional local iterations is not limited to use with min-sum based decoding or to any particular LDPC decoding algorithm. The non-layer LDPC decoder 500 may be used, for example, in place of the LDPC decoder 222 of Fig. 2.

The non-layer LDPC decoder 500 is provided with LLR values from an input channel 502, which may be stored in an LLR memory 504. Stored values 506 are provided to an adder/subtractor array 510, also referred to as a variable node processor or variable node unit (VNU) or as a portion of a VNU. The adder/subtractor array 506 updates the perceived value of symbols based on the value from input channel 502 and on C2V message vectors 512. The adder/subtractor array 510 yields an external LLR output 514 to a check sum calculation circuit 516, which generates a parity check output 520. For example, check sum calculation circuit 516 may include multiplexers and XOR circuits to calculate parity check equation $\underline{v} \cdot H^T = \underline{0}$ over $GF(q)$, where $\underline{v} \in GF(q)^N$, and where $\underline{v}$ is a codeword vector and $H^T$ is the transform of the H matrix for the LDPC decoder. The adder/subtractor array 510 also yields an external LLR output 522 to a normalization/saturation circuit 524, which generates a hard decision output 526.

The adder/subtractor array 510 performs an update function, adding C2V message vectors 512 to symbol values, and generates V2C message vectors 530 setting forth the updated likelihood or LLR value for each element in the Galois Field for each symbol in the data set. The V2C message vectors 530 are provided to a normalization/scaling/saturation circuit 532 which scales the LLR values and converts them to normalized V2C message vectors 534. The normalized V2C message vectors 534 contain a hard decision (an indication of the most likely GF element), and LLR values for the remaining GF elements for each symbol, each normalized to the hard decision. For example, in a GF(4) LDPC decoder, the normalization/scaling/saturation circuit 532 takes the four LLR data values for each symbol, identifies the highest LLR data value of the four values, and normalizes the four LLR data values to the value of the highest LLR data value. An example of this is shown using the following example symbol:

| Hard Decision | 00 | 01 | 10 | 11 |
|---|---|---|---|---|
| LLR Data Value | 10 | 15 | 22 | 6 |

In this example, the normalization/scaling/saturation circuit 532 selects the LLR data value '22' corresponding to the hard decision '10'. Next, the LLR data values corresponding to hard decision values '00', '01', '10' and '11' are normalized to LLR data value '22' by subtracting '22' from each of the LLR data values to yield the following normalized symbol:

| Hard Decision | 00 | 01 | 10 | 11 |
|---|---|---|---|---|
| Normalized LLR Data Value | -12 | -7 | 0 | -16 |

The LLR values may also be scaled in normalization/scaling/saturation circuit 532, multiplying each of the normalized LLR data values by a scaling factor. The scaling factor may be user programmable. As an example, with a scaling factor of 0.5, the normalized V2C message vectors 534 might include the following scaled symbol based on the current example:

| Hard Decision | 00 | 01 | 10 | 11 |
|---|---|---|---|---|
| Normalized LLR Data Value | -6 | -4 | 0 | -8 |

The V2C message vectors 534 are provided to a rearranger 536 which shuffles messages on the boundaries at message edges, randomizing noise and breaking dependencies between messages, and yielding rearranged V2C message vectors 540 and 542. The rearranged V2C message vectors 540 and 542 are provided to barrel shifters 544 and 546, respectively, which shift the symbol values in the rearranged V2C message vectors 540 and 542 to generate the next circulant sub-matrix, yielding shifted LLR values 550 and 552. In some embodiments, the code structure of the codeword provided at input channel 502 has a code structure matrix of the following form:

$$\begin{bmatrix} P_{1,1} & P_{1,2} & \cdots & P_{1,j} & \cdots & P_{1,L} \\ P_{2,1} & P_{2,2} & \cdots & P_{2,j} & \cdots & P_{2,L} \\ P_{3,1} & P_{2,2} & \cdots & P_{3,j} & \cdots & P_{3,L} \\ R_1 & R_2 & \cdots & R_j & \cdots & R_L \end{bmatrix}$$

$$R_j = \begin{bmatrix} q_{p_1 \times p_1}^{j+0} & q_{p_1 \times p_1}^{j+1} & \cdots & q_{p_1 \times p_1}^{j+k} \end{bmatrix}$$

where each of $P_{I,J}$ are pxp circulants with weight 1, or permutations of the identity matrix, and the circulant size L is the row weight. The following is an example of a pxp circulant representative of $P_{I,J}$:

$$P_{I,J} = \begin{bmatrix} 0 & \alpha & 0 & \cdots & 0 \\ 0 & 0 & \alpha & \cdots & 0 \\ \vdots & \vdots & \vdots & \ddots & \vdots \\ 0 & 0 & 0 & \cdots & \alpha \\ \alpha & 0 & 0 & \cdots & 0 \end{bmatrix}$$

The barrel shifters 544 and 546 are operable to shift the currently received circulant to an identity matrix. Such an identity matrix may be as follows:

$$P_{I,J} = \begin{bmatrix} \alpha & 0 & 0 & \cdots & 0 \\ 0 & \alpha & 0 & \cdots & 0 \\ \vdots & \vdots & \vdots & \ddots & \vdots \\ 0 & 0 & 0 & \cdots & 0 \\ 0 & 0 & 0 & \cdots & \alpha \end{bmatrix}$$

Barrel shifter 544 provides shifted output 550, which contains the magnitude and sign of the hard decision HD. Barrel shifter 546 provides shifted output 552, which contains the magnitudes of the remaining LLR values, normalized to the hard decision HD. The shifted output 550 is provided to a parity/HD computation circuit 554 which calculates the accumulative sign for the hard decisions in shifted output 550, storing the resulting sign values 556 for each non-zero element of the portion of the H matrix being processed, and the hard decisions, in a parity/HD memory 560.

The shifted output 552 is provided to an LLR comparison circuit 562, which calculates the first minimum LLR value or sub-message $min_1(d)$, (i.e., the lowest LLR value), the index $idx(d)$ of $min_1(d)$ (i.e., the location in the row corresponding to the first minimum LLR data value), and the second minimum LLR value or sub-message $min_2(d)$, (i.e., the second lowest LLR value) or minimum of all sub-messages excluding $min_1(d)$, for each nonzero symbol $d$ in the Galois Field based on all extrinsic V2C messages in the portion of the H matrix being processed. In other words, the sub-messages for a particular symbol $d$ are gathered from messages from all extrinsic inputs for the portion of the H matrix being processed, and the $min_1(d)$, $idx(d)$ and $min_2(d)$ is calculated based on the gathered sub-messages for that symbol $d$. For a Galois Field with $q$ symbols, the check node will calculate the $min_1(d)$, $idx(d)$ and $min_2(d)$ sub-message for each of the $q$-1 non-zero symbols in the field except the most likely symbol, the hard decision HD.

Again, columns in the H matrix represent variable nodes, rows represent check nodes, and non-zero values in the H matrix indicate a connection between the column and row at the non-zero intersection. In general, the min-sum based decoding algorithm for fractional local iteration processing identifies the lowest extrinsic input value to a check node from each connected variable node in the portion or segment of the H matrix being processed, for each non-zero element of the Galois Field except the most likely symbol or HD, by finding the lowest and next lowest LLR value for each non-zero Galois Field element other than the HD among the connected variable nodes (or non-zero row values) in the portion of the H matrix being processed.

Because the H matrix is divided into multiple segments, for example a left side and a right side, the $min_1(d)$,

$idx(d)$ and $min_2(d)$ values are alternately calculated for each side of the H matrix so that check node updates can be performed after a fractional iteration, for example after processing the left side based on newly identified $min_1\_r(d)$, $idx\_r(d)$ and $min_2\_r(d)$ values for the right side and on previously identified $min_1\_l(d)$, $idx\_l(d)$ and $min_2\_l(d)$ values for the left side, or after processing the right side based on newly identified $min_1\_l(d)$, $idx\_l(d)$ and $min_2\_l(d)$ values for the left side and on previously identified $min_1\_r(d)$, $idx\_r(d)$ and $min_2\_r(d)$ values for the right side.

Identification of the lowest and next lowest LLR value is performed in the LLR comparison circuit 562, with the results 564 (for a two-segment H-matrix) divided into left side results 566 and right side results 570, for example by switch 572. The left side results 566 (or $min_1\_l(d)$, $idx\_l(d)$ and $min_2\_l(d)$ values) are stored in a left register array 574. The right side results 570 (or $min_1\_r(d)$, $idx\_r(d)$ and $min_2\_r(d)$ values) are stored in a right register array 576. The register arrays 574 and 576 for a two-segment LDPC decoder store left and right sets of $min_1(d)$, $idx(d)$ and $min_2(d)$ values for each non-zero GF element other than the HD at each check node or row of the H matrix. In some embodiments of a GF(4) decoder, there is a set of three $min_1(d)$, $idx(d)$ and $min_2(d)$ registers for the left side of the H matrix and three $min_1(d)$, $idx(d)$ and $min_2(d)$ registers for the right side of the H matrix, for each check node or row of the H matrix. With a code structure matrix having three rows, the left register array 574 and right register array 576 would each store three sets of first minimum LLR data value, second minimum LLR data value, index value as shown in the example below:

| Row 1 | First Minimum LLR Value |
| | Second Minimum LLR Value |
| | Index Value |
| Row 2 | First Minimum LLR Value |
| | Second Minimum LLR Value |
| | Index Value |
| Row 3 | First Minimum LLR Value |
| | Second Minimum LLR Value |
| | Index Value |

Before starting the LLR compare process in the LLR comparison circuit 562 for each side of the H matrix, the left register array 574 or right register array 576 is reset to an initial value, for example zero. As the first non-zero LLR values are received when processing each column in that side of the H matrix, they overwrite the initial zero values. As processing of each column in that side of the H matrix continues, if the LLR value for a non-zero GF element is lower than the value in the $min_1(d)$ register, the $min_1(d)$ register is updated with the LLR value for the non-zero GF element, the previous value in the $min_1(d)$ register is copied into the $min_2(d)$ register as the next lowest value, and the $idx(d)$ register is updated with the index of the current working column. If the LLR value for the non-zero GF element was greater than the value in the $min_1(d)$ register but lower than the value in the $min_2(d)$ register, the $min_2(d)$ register is updated with the LLR value for the GF element. As each column is processed, this LLR comparison is performed for the sets of $min_1(d)$, $idx(d)$ and $min_2(d)$ registers for each check node or row in the column.

At the end of processing a segment of the H matrix in the LLR comparison circuit 562, a select network 578 performs a check node update based on the stored left side results 580 (or $min_1\_l(d)$, $idx\_l(d)$ and $min_2\_l(w$ values) stored in the left register array 574 and on the stored right side results 582 (or $min_1\_r(d)$, $idx\_r(d)$ and $min_2\_r(d)$ values) stored in the right register array 576. The check node updates are based on newly identified values for one side (e.g., 574) and previously identified values for the other side (e.g., 576), with the side having the newly identified values alternating between the left side and the right side as the H matrix is processed. For example, once all columns in the left side (e.g., 402) of the H matrix have been processed, and after an update delay, the check node update is performed based on the new $min_1\_l(d)$, $idx\_l(d)$ and $min_2\_l(d)$ values stored in the left register array 574 and on the old $min_1\_r(d)$, $idx\_r(d)$ and $min_2\_r(d)$ values stored in the right register array 576. The right side (e.g., 404) of the H matrix is then processed as disclosed above, first resetting the right register array 576. When the right side of the H matrix has been processed, and after an update delay (e.g., 320), another check node update may be performed based on the old $min_1\_r(d)$, $idx\_l(d)$ and $min_2\_l(d)$ values stored in the left register array 574 and on the new $min_1\_r(d)$, $idx\_r(d)$ and $min_2\_r(d)$ values stored in the right register array 576.

The LLR comparison circuit 562, register arrays 574 and 576, and select network 578 may be collectively referred to as a check node processor or check node unit (CNU). The simplified min-sum based CNU disclosed herein and which may be used in some embodiments of a simplified min-sum based non-layer LDPC decoder is also referred to as a compression circuit. The select network 578 selects as output 584 either the $min_1(d)$ or $min_2(d)$ to be used in the C2V message 512 such that only extrinsic values are selected. If the current column index is equal to the index of the minimum value, meaning that the C2V message is being prepared for a variable node that provided the $min_1(d)$ value, then the value to be used in the C2V message 512 is the second minimum value $min_2(d)$. Otherwise, the value to be used in the C2V message 512 is the first minimum value $min_1(d)$. The select network 578 also considers the $min_1(d)$ or $min_2(d)$ values from both sides of the H matrix, selecting the lowest LLR value from them both. When processing the left side of the H matrix, this may be accomplished according to the equation:

$$sel[d] = \min\left(\left((circ\_idx == idx\_l[d])?\, min_2\_l[d]:min_1\_l[d]\right), min_1\_r[d]\right) \qquad \text{(Eq 1)}$$

where $d$ is the GF element index, where $circ\_idx$ is the index of the working column, that is, the index of the variable node for which the C2V message is being generated, and where idr_l is the column index of the $min_1\_l(d)$ value. For a GF(4) decoder, $d$=0,1,2. The outer min statement selects the extrinsic minimum LLR value from either the left or the right side. Because in this instance the left side of the H matrix is being processed, the index $circ\_idx$ of the working column is in the left side, and $min_1\_r(d)$ cannot have come from the variable node at the working column and is therefore from an extrinsic input. In contrast, the $min_1\_l(d)$ may have come from the variable node at the working column, so the $idx\_l(d)$ is compared with the working column index $circ\_idx$. If they are equal, then the $min_1\_l(d)$ is not an extrinsic input and the $min_2\_l(d)$ value is used rather than $min_1\_l(d)$. Notably, the equation may be adapted to select from among more than two portions if the H matrix is further divided.

When processing the right side of the H matrix, the select network 578 selects the lowest LLR value from both sides of the H matrix according to the equation:

$$sel[d] = \min\left(min_1\_l[d], \left((circ\_idx == idx\_r[d])?\, min_2\_r[d]:min_1\_r[d]\right)\right) \qquad \text{(Eq 2)}$$

where $idx\_r$ is the column index of the $min_1\_r(d)$ value for the right side. Again, the outer min statement selects the extrinsic minimum LLR value from either the left or the right side. Because in this instance the right side of the H matrix is being processed, the index $circ\_idx$ of the working column is in the right side, and $min_1\_l(d)$ cannot have come from the variable node at the working column and is therefore from an extrinsic input. In contrast, the $min_1\_r(d)$ may have come from the variable node at the working column, so the $idx\_r(d)$ is compared with the working column index $circ\_idx$. If they are equal, then the $min_1\_r(d)$ is not an extrinsic input and the $min_2\_r(d)$ value is used rather than $min_1\_r(d)$.

The R values or LLR values for each element of the Galois Field making up a portion of the C2V message vectors 512 are calculated based on the $sel[d]$ in the select network 578, for example according to equations 3-5 in a GF(4) LDPC decoder:

$$R[0] = min(sel[0], sel[1] + sel[2]) \qquad \text{(Eq 3)}$$

$$R[1] = min(sel[1], sel[0] + sel[2]) \qquad \text{(Eq 4)}$$

$$R[2] = min(sel[2], sel[0] + sel[1]) \qquad \text{(Eq 5)}$$

For an LDPC decoder with more Galois Field elements, there would be additional equations for the extra R terms.

The hard decision HD and sign to be used in the C2V message 512 is provided at the output 586 of parity/HD memory 560, with the sign or parity calculated as the XOR of the cumulative sign and the current sign of the symbol. The R_HD value to be used as the hard decision value in the C2V message vectors 512 may be calculated according to equation 6:

$$R_{HD} = sgn\_l\ XOR\ sgn\_r\ XOR\ Q\_HD \qquad \text{(Eq 6)}$$

where $sgn\_l$ and $sgn\_r$ are sign or parity values for each portion of the H matrix, and $Q\_HD$ is the previous hard decision in the V2C message vectors 540, combined in XOR operations. Again, if the H matrix were divided into more than two portions, equation 6 would have additional sign terms. The hardware used to implement equations 1-6 may be shared and used for each portion of the H matrix, or may be duplicated for each portion of the H matrix. The output 586 of parity/HD memory 560 and the output 584 of select network 578 are provided to barrel shifters 588 and 590, respectively, which shift the hard decisions and their signs in output 586 and the C2V message values in output 584 to yield shifted hard decisions and signs 592 and shifted C2V message values 594, respectively, shifting between circulant sub-matrices. The shifted C2V message values 594 and shifted hard decisions and signs 592 are combined and processed in an inverse rearranger 596 which combines the inputs 592 and 594 and which reverses the effect of rearranger 536 to yield C2V message vectors 512. The combining portion of inverse rearranger 596 is also referred to herein as a data decompression circuit, and reassembles rows to yield an approximation of the original data.

A fractional iteration scheduler 599 determines the number of full and fractional local decoding iterations to perform in the non-layer LDPC decoder 500 during a global iteration, based on the processing time in an external detector (e.g., channel detector 204 or 210). In some embodiments, the fractional iteration scheduler 599 assigns the number of full and fractional local decoding iterations that will come close to the detector processing time without exceeding it. In some other embodiments, the fractional iteration scheduler 599 may allow the decoder processing time to slightly exceed the detector processing time. The fractional iteration scheduler 599 may cause fractional local decoding iterations to be performed at the beginning, middle or end of a global local decoding iteration. The fractional iteration scheduler 599 may determine in advance or at the beginning of a global decoding iteration the number of full and fractional local decoding iterations to perform in the non-layer LDPC decoder 500, or may determine at the beginning of each local decoding iteration whether enough decoder processing time remains for a full or a fractional local decoding iteration without exceeding the detector processing time.

In some embodiments, the fractional iteration scheduler 599 balances the decoder processing time with the detector processing time for the same data set. In these embodiments, because the detector and the decoder may be processing different data sets at any given time in a ping-pong data processing scheme, the processing time of the detector and decoder of a single time slot may not be balanced, although the average processing time of the detector and decoder for a group of data sets will be balanced. In other embodiments, the fractional iteration scheduler 599 may balance the decoder processing time of the data set currently being decoded with the detector processing time of the data set currently being detected, although they may be different data sets.

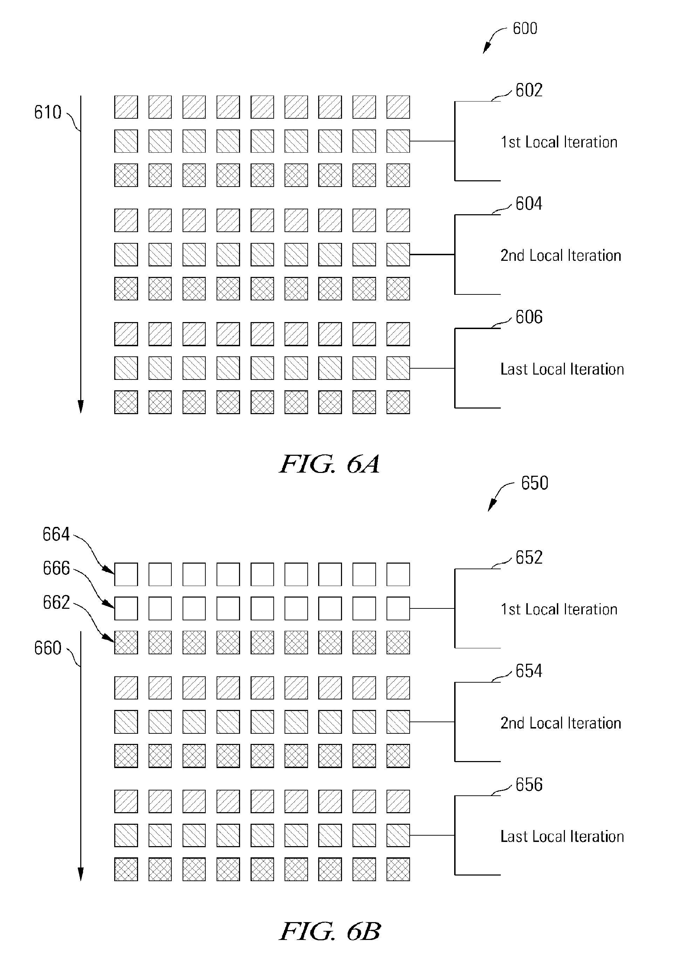

Turning to Figs. 6A and 6B, the division of an H matrix 600 and 650 into segments to enable fractional local iterations in an LDPC layer decoder is depicted in accordance with some embodiments of the present invention. In the layer decoder, the H matrix 600 and 650 is decoded in layers, with each layer containing one or more rows. A layer refers to the row or rows that are processed concurrently in the decoder. During each local decoding iteration in the layer decoder, each row in the H matrix is processed once.

With fractional local iterations disabled in the LDPC layer decoder, or if a fractional local iteration is not needed during a global decoding iteration to match the detector processing time, the layer decoding of the H matrix may be as shown in Fig. 6A. In this example, the H matrix 600 includes three layers (distinguished by different cross-hatch patterns), each of which may contain one or more rows of the H matrix. All three layers of the H matrix 600 are processed fully during the first local iteration 602, the second local iteration 604 and the third and last iteration 606 of this example. The global decoding iteration 610 in the LDPC layer decoder thus performs three full local decoding iterations, each containing all layers of the H matrix 600.

When fractional local iterations are enabled or used in the LDPC layer decoder, one or more layers of the H matrix may be omitted from a local decoding iteration. For example, as shown in Fig. 6B, the first two layers 664 and 666 of the H matrix 650 may be omitted from processing in a fractional local iteration 652, processing only the last layer 662 to reduce the processing time of the first local iteration 652 in the LDPC layer decoder. The global iteration 660 thus begins by processing the last layer 662 of the H matrix 650 in the first local iteration 652, followed by two full local iterations 654 and 656. The fractional local iterations in the LDPC layer decoder are thus achieved by processing only a subset of the layers in the H matrix 650. When performing check node calculations and generating C2V messages for a fractional local iteration, old and new data may be combined to generate C2V messages for entire H matrix 650, with the C2V messages being based on new data for the layers last processed in a fractional local iteration and on older data for layers omitted from the fractional local iteration, with the older data coming from the last full local iteration in which those layers were processed.

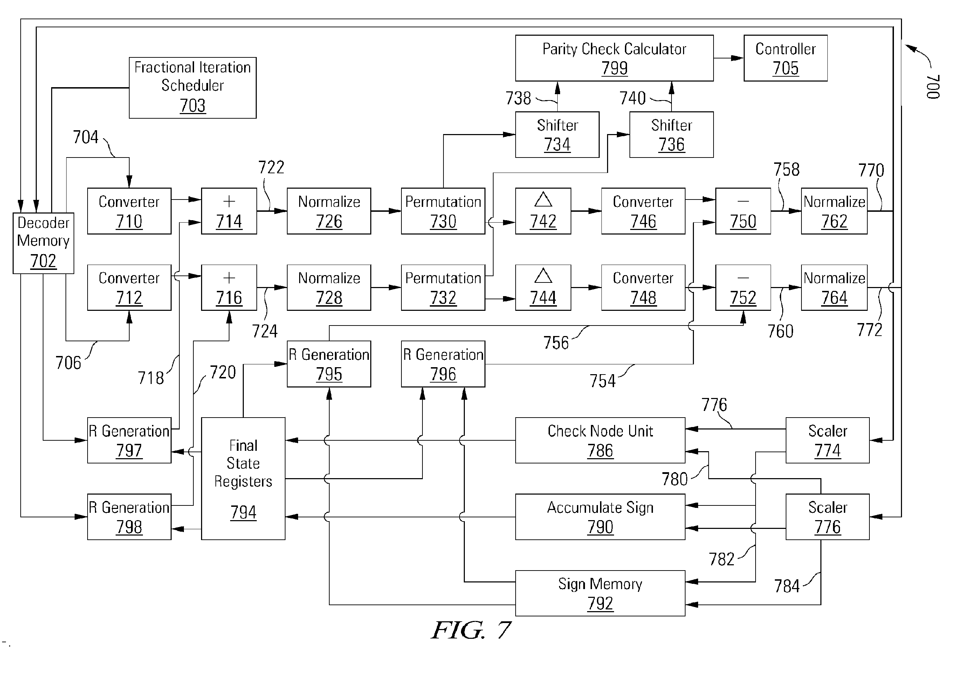

Turning to Fig. 7, an LDPC layer decoder 700 with fractional local iterations is disclosed in accordance with some embodiments of the present invention, applying a simplified min-sum based decoding algorithm. Again, it is important to note that the LDPC layer decoder 700 with fractional local iterations is not limited to use with min-sum based decoding or to any particular LDPC decoding algorithm. The LDPC layer decoder 700 may be used, for example, in place of the LDPC decoder 222 of Fig. 2. In this example embodiment, two circulants are processed in parallel. A decoder memory 702 stores soft LLR input values, Q values, and soft LLR output P values. The decoder memory 702 is a ping pong memory. The decoder memory 702 provides Q values 704 and 706 of the connected (or previous) layer to converters 710 and 712, respectively, each based on a different circulant being processed. In a GF(4) embodiment, the Q values 704 and 706 each consist of one hard decision and three soft LLR values.

The converters 710 and 712 convert the Q values from a format containing a hard decision and three soft LLR values to a format containing four soft LLR values, with the information being equivalent in the two formats. Adders 714 and 716 add the connected layer's Q value (converted by converters 710 and 712) to the connected layer's R value 718 and 720 of each symbol of a circulant respectively, yielding the soft LLR values 722 and 724 of each symbol. In an embodiment with GF(4), each adder 714 and 716 consists of four adders each, adapted to add the connected layer's Q value with the connected layer's R value of each symbol of a circulant respectively to obtain the soft LLR values 722 and 724 of each symbol.

The soft LLR values 722 and 724 of each symbol are provided to normalizers 726 and 728, which compare the four values in each of the soft LLR values 722 and 724 to identify the minimum of each, and which subtract that minimum from the other three soft LLR values, thereby normalizing each of the soft LLR values 722 and 724 to their respective minimum.

The normalized variable node LLR values from normalizers 726 and 728 are provided to permutation circuits 730 and 732, which rearrange the variable node updated values to prepare for the check node update and apply the permutations specified by the non-zero elements of the H matrix. In a GF(4) embodiment, the four elements 0-3 of the Galois Field are 0, 1, $\alpha$, $\alpha^2$. The permutation applied by permutation circuits 730 and 732 is multiplication in the Galois Field. Element 2 ($\alpha$) multiplied by element 1 (1) equals $\alpha$ x 1 or $\alpha$, which is element 2. Similarly, element 2x2=$\alpha$x$\alpha$=$\alpha^2$, which is element 3. Element 2x3=$\alpha$x$\alpha^2$ = 1, which is element 1. Thus, element 2 multiplied by 1, 2 and 3 results in elements 2, 3, and 1, which are permutations of elements 1, 2 and 3. In the parity check calculation, each hard decision value is multiplied by the non-zero elements (1, 2, or 3) of the H matrix, and the results are XORed together.

Shifters 734 and 736 process the output of permutation circuits 730 and 732 to shift the soft LLR values back to column order to yield soft LLR outputs 738 and 740 as the hard decisions used by the parity check calculator (e.g., hard decisions 502 and 504 used by parity check calculator 500). Shifters 734 and 736 are used to shift from row order to column order because the LDPC layer decoder 700 processes data in row order, but the output total soft LLR is ordered by column in order to subtract the input LLR which is in column order to get the extrinsic LLR value. Delta shifters 742 and 744 also process the output of permutation circuits 730 and 732, shifting the output of the permutation circuits 730 and 732 by the difference in the circulant shift numbers of the current layer and the connected layer. In a given column there are circulants with different shift numbers, and the delta shifters 742 and 744 compensate for the different shift numbers of the current layer and the connected layer.

The output of delta shifters 742 and 744 is provided to converters 746 and 748 which convert from the format containing one hard decision and three soft LLR values back to the format containing four soft LLR values. Subtractors 750 and 752 then subtract the R values 754 and 756 of the symbols of the current layer from the soft LLR P values provided by converters 746 and 748 to obtain Q values 758 and 760 of the symbols of the current layer. The Q values 758 and 760 of the symbols of the current layer are then normalized in normalizers 762 and 764, which compare the four values in each of the Q values 758 and 760 to identify the minimum of each, and which subtract that minimum from the other three elements of the Q values 758 and 760, thereby normalizing each of the Q values 758 and 760 to their respective minimum. The normalized Q values 770 and 772 are provided to the decoder memory 702 to update the Q values of the current layers, and also to scalers 774 and 776 to obtain the new Q values to perform the check node to variable node update.

Scalers 774 and 776 scale the normalized Q values 770 and 772 from the normalizers 762 and 764, yielding the new Q values 778 and 780, or absolute soft values, along with the Q values signs 782 and 784. The new Q values 778 and 780 and their signs 782 and 784 are provided to the check node unit 786 which finds the minimum value, second or next minimum value and the index of the minimum value. The new Q values signs 782 and 784 are also provided to a sign accumulator 790, which calculates and stores the cumulative sign for the current layer of the Q values 778 and 780, and to a sign memory 792 which stores the sign value of each non-zero element of the H matrix.

Final state registers 794 store the final state consisting of the minimum value, the second minimum value, the index of the minimum value, and cumulative sign of the current layer. These final state values are provided to two sets of R generators 795, 796, 797 and 798, which generate the R value for the connected layer or current layer based on the final state and current column index of the symbol. R generators 795 and 796 generate the R values for the current layer of the two circulants being processed, and R generators 797 and 798 generate the R values for the connected layer of the two circulants being processed. If the current column index is equal to the index of the minimum value, then the value of R is the second minimum value. Otherwise, the value of R is the minimum value of that layer. The sign of R is the XOR of the cumulative sign and the current sign of the symbol.

During operation of the LDPC layer decoder 700, as Q values and R values are iteratively circulated through the decoder 700, a parity check calculator 799 calculates parity checks based on soft LLR outputs 738 and 740. If the unsatisfied check number calculated by the parity check calculator 799 is equal to zero after all layers have been processed, the LDPC layer decoder 700 has converged and processing can be halted and the decoded data provided to a controller 705.

A fractional iteration scheduler 703 determines the number of full and fractional local decoding iterations to perform in the LDPC layer decoder 700 during a global iteration, based on the processing time in an external detector (e.g., channel detector 204 or 210). In some embodiments, the fractional iteration scheduler 703 assigns the number of full and fractional local decoding iterations that will come close to the detector processing time without exceeding it. In some other embodiments, the fractional iteration scheduler 703 may allow the decoder processing time to slightly exceed the detector processing time. The fractional iteration scheduler 703 may cause fractional local decoding iterations to be performed at the beginning, middle or end of a global local decoding iteration. The fractional iteration scheduler 703 may determine in advance or at the beginning of a global decoding iteration the number of full and fractional local decoding iterations to perform in the LDPC layer decoder 700, or may determine at the beginning of each local decoding iteration whether enough decoder processing time remains for a full or a fractional local decoding iteration without exceeding the detector processing time.

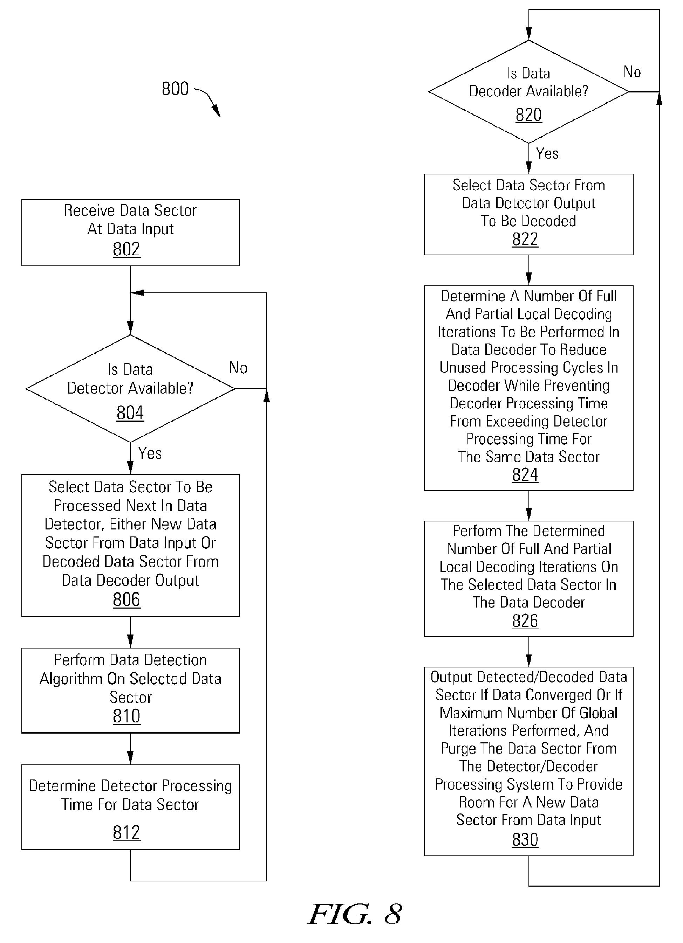

Turning to Fig. 8, a flow diagram 800 is depicted of a data detection and decoding operation using an LDPC decoder with fractional local iterations in accordance with some embodiments of the present invention. Following flow diagram 800, a data set or sector is received at a data input. (Block 802) When the data detector is available (block 804), a data sector is selected to be processed next in the data detector. (Block 806) This may be a new data sector from the data input, or a decoded data sector from a data decoder output to be processed with another global iteration. A data detection algorithm is performed on the selected data sector. (Block 810) The detector processing time is determined for the data sector. (Block 812) The detector processing time may be measured in clock cycles or any other unit of measurement, or may be specified in relation to an expected or standard processing time. The detector processing time may be calculated once per data set, or each time the data set passes through the detector.

In parallel with the data detection process, a data decoding process may be performed, with data sets alternating in ping pong fashion between the data detector and the data decoder. When the data decoder is available (block 820), a data set from the data detector output is selected to be decoded. (Block 822) In some embodiments, the data sets are buffered between the data detector and data decoder in a central ping pong buffer. The number of full and partial local decoding iterations to be performed in data decoder is determined (block 824) to reduce unused processing cycles in the decoder while preventing the decoder processing time from exceeding the detector processing time for the same data sector. The number of full and partial local decoding iterations may be determined in advance of decoding, or the detector processing time may be specified to the decoder, enabling the decoder to process the data set normally until one more full iteration in the decoder would cause decoder processing time to exceed detector processing time for the sector. At that point, the decoder may run a partial iteration if that would not cause the decoder processing time to exceed the detector processing time. The determined number of full and partial local decoding iterations is performed on the selected data sector in the data decoder. (Block 826) The detected/decoded data set is output (block 830) if data converged or if the maximum number of global iterations was performed on the data set. The data set is purged from the detector/decoder processing system after it is output, to provide room for a new data sector from the data input.

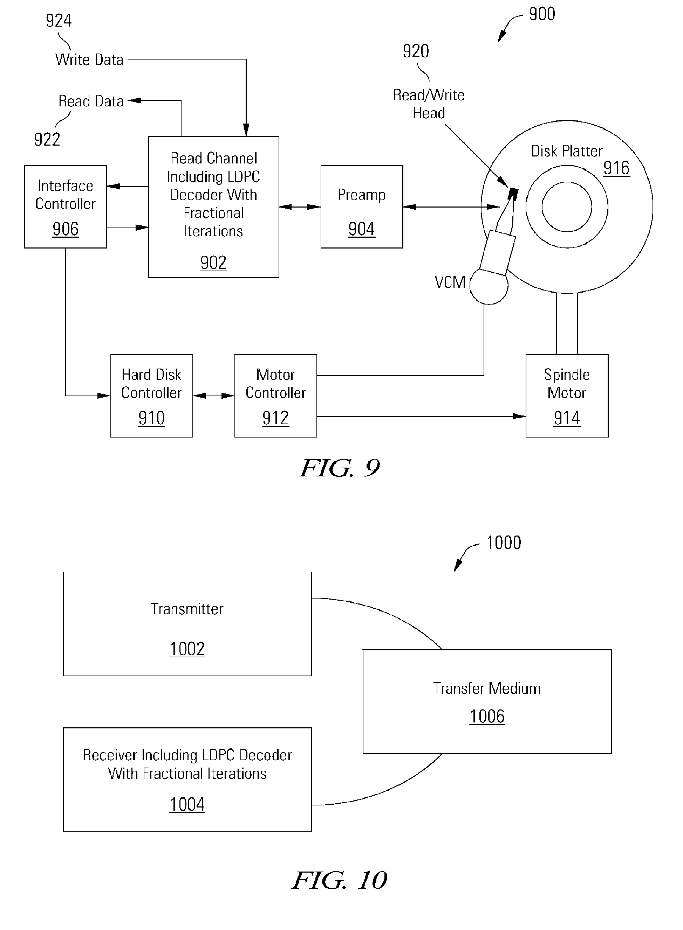

Although the LDPC decoder with fractional local iterations disclosed herein is not limited to any particular application, several examples of applications are presented in Figs. 9 and 10 that benefit from embodiments of the present invention. Turning to Fig. 9, a storage system 900 including a read channel circuit 902 having an LDPC decoder with fractional local iterations is shown in accordance with some embodiments of the present invention. Storage system 900 may be, for example, a hard disk drive. Storage system 900 also includes a preamplifier 904, an interface controller 906, a hard disk controller 910, a motor controller 912, a spindle motor 914, a disk platter 916, and a read/write head 920. Interface controller 906 controls addressing and timing of data to/from disk platter 916. The data on disk platter 916 consists of groups of magnetic signals that may be detected by read/write head assembly 920 when the assembly is properly positioned over disk platter 916. In one embodiment, disk platter 916 includes magnetic signals recorded in accordance with either a longitudinal or a perpendicular recording scheme.

In a typical read operation, read/write head assembly 920 is accurately positioned by motor controller 912 over a desired data track on disk platter 916. Motor controller 912 both positions read/write head assembly 920 in relation to disk platter 916 and drives spindle motor 914 by moving read/write head assembly to the proper data track on disk platter 916 under the direction of hard disk controller 910. Spindle motor 914 spins disk platter 916 at a determined spin rate (RPMs). Once read/write head assembly 920 is positioned adjacent the proper data track, magnetic signals representing data on disk platter 916 are sensed by read/write head assembly 920 as disk platter 916 is rotated by spindle motor 914. The sensed magnetic signals are provided as a continuous, minute analog signal representative of the magnetic data on disk platter 916. This minute analog signal is transferred from read/write head assembly 920 to read channel circuit 902 via preamplifier 904. Preamplifier 904 is operable to amplify the minute analog signals accessed from disk platter 916. In turn, read channel circuit 902 decodes and digitizes the received analog signal to recreate the information originally written to disk platter 916. This data is provided as read data 922 to a receiving circuit. As part of decoding the received information, read channel circuit 902 processes the received signal using an LDPC decoder with fractional local iterations. Such an LDPC decoder with fractional local iterations may be implemented consistent with that disclosed above in relation to Figs. 2-7. In some cases, LDPC decoding with fractional local iterations may be performed consistent with the flow diagram disclosed above in relation to Fig. 8. A write operation is substantially the opposite of the preceding read operation with write data 924 being provided to read channel circuit 902. This data is then encoded and written to disk platter 916. It should be noted that various functions or blocks of storage system 900 may be implemented in either software or firmware, while other functions or blocks are implemented in hardware.

Storage system 900 may be integrated into a larger storage system such as, for example, a RAID (redundant array of inexpensive disks or redundant array of independent disks) based storage system. Such a RAID storage system increases stability and reliability through redundancy, combining multiple disks as a logical unit. Data may be spread across a number of disks included in the RAID storage system according to a variety of algorithms and accessed by an operating system as if it were a single disk. For example, data may be mirrored to multiple disks in the RAID storage system, or may be sliced and distributed across multiple disks in a number of techniques. If a small number of disks in the RAID storage system fail or become unavailable, error correction techniques may be used to recreate the missing data based on the remaining portions of the data from the other disks in the RAID storage system. The disks in the RAID storage system may be, but are not limited to, individual storage systems such as storage system 900, and may be located in close proximity to each other or distributed more widely for increased security. In a write operation, write data is provided to a controller, which stores the write data across the disks, for example by mirroring or by striping the write data. In a read operation, the controller retrieves the data from the disks. The controller then yields the resulting read data as if the RAID storage system were a single disk.

Turning to Fig. 10, a data transmission system 1000 including a receiver 1004 having an LDPC decoder with fractional local iterations is shown in accordance with various embodiments of the present invention. Data transmission system 1000 includes a transmitter 1002 that is operable to transmit encoded information via a transfer medium 1006 as is known in the art. The encoded data is received from transfer medium 1006 by a receiver 1004. Receiver 1004 processes the received input to yield the originally transmitted data. As part of processing the received information, receiver 1004 decodes received data with an LDPC decoder with fractional local iterations. Such an LDPC decoder with fractional local iterations may be implemented consistent with that disclosed above in relation to Figs. 2-7. In some cases, LDPC decoding with fractional local iterations may be performed consistent with the flow diagram disclosed above in relation to Fig. 8.

It should be noted that the various blocks discussed in the above application may be implemented in integrated circuits along with other functionality. Such integrated circuits may include all of the functions of a given block, system or circuit, or a portion of the functions of the block, system or circuit. Further, elements of the blocks, systems or circuits may be implemented across multiple integrated circuits. Such integrated circuits may be any type of integrated circuit known in the art including, but are not limited to, a monolithic integrated circuit, a flip chip integrated circuit, a multichip module integrated circuit, and/or a mixed signal integrated circuit. It should also be noted that various functions of the blocks, systems or circuits discussed herein may be implemented in either software or firmware. In some such cases, the entire system, block or circuit may be implemented using its software or firmware equivalent. In other cases, the one part of a given system, block or circuit may be implemented in software or firmware, while other parts are implemented in hardware.

In conclusion, various embodiments of the present invention provide novel systems, devices, methods and arrangements for an LDPC decoder with fractional local iterations. While detailed descriptions of one or more embodiments of the invention have been given above, various alternatives, modifications, and equivalents will be apparent to those skilled in the art without varying from the spirit of the invention. Therefore, the above description should not be taken as limiting the scope of the invention, which is defined by the apended claims.

**Claims**

1.    An apparatus for processing data comprising:

   a data detector operable to detect data values in a data set; and
   a low density parity check decoder operable to iteratively perform a plurality of decoding iterations on the data set, wherein the plurality of decoding iterations comprises a selection of full decoding iterations and fractional decoding iterations to balance a decoder processing time with a detector processing time.

2.    The apparatus of claim 1, wherein the low density parity check decoder is operable to determine a number of the full decoding iterations and a number of the fractional decoding iterations that can be included in the selection of full decoding iterations and fractional decoding iterations without the decoder processing time exceeding the detector processing time.

3.    The apparatus of claim 1 or 2, wherein the low density parity check decoder is operable to include as many as possible of the full decoding iterations and of the fractional decoding iterations in the selection of full decoding iterations and fractional decoding iterations without the decoder processing time exceeding the detector processing time.

4.  The apparatus of any one of the preceding claims, further comprising a fractional iteration controller operable to communicate the detector processing time from the data detector to the low density parity check decoder.

5.  The apparatus of any one of the preceding claims, wherein the data detector comprises a soft output Viterbi algorithm detector.

6.  The apparatus of any one of the preceding claims, wherein the decoder processing time and the detector processing time are balanced for a same data set.

7.  The apparatus of any one of the preceding claims, wherein the decoder processing time and the detector processing time are balanced for different data sets that are concurrently processed in the data detector and the low density parity check decoder.

8.  The apparatus of any one of the preceding claims, wherein:

    the low density parity check decoder comprises a non-layer decoder, and wherein the fractional decoding iterations comprise a local decoding iteration in which a subset of a plurality of columns in an H matrix for the non-layer decoder are processed during the local decoding iteration; and/or
    the low density parity check decoder comprises a layer decoder, and wherein the fractional decoding iterations comprise a local decoding iteration in which a subset of a plurality of layers in an H matrix for the layer decoder are processed during the local decoding iteration.

9.  The apparatus of any one of the preceding claims, wherein the low density parity check decoder is operable to generate check node to variable node messages in one of the fractional decoding iterations based on a combination of new data generated in said one of the fractional decoding iterations and old data generated in one of the full decoding iterations.

10. The apparatus of any one of the preceding claims, wherein:

    the apparatus is implemented as an integrated circuit;
    the apparatus is incorporated in a storage device, preferably wherein the storage device comprises a redundant array of independent disks; and/or
    the apparatus is incorporated in a transmission system.

11. A method for processing data comprising:

    detecting data values of a data set in a data detector;
    determining a detector processing time for the data set in the data detector; and
    performing a plurality of local decoding iterations on the data set in a low density parity check decoder, wherein the plurality of local decoding iterations comprises a selection of full decoding iterations and fractional decoding iterations to balance a decoder processing time with the detector processing time.

12. The method of claim 11, further comprising including as many as possible of the full decoding iterations and the fractional decoding iterations in the plurality of local decoding iterations without the decoder processing time exceeding the detector processing time.

13. The method of claim 11 or 12, wherein:

    the low density parity check decoder comprises a non-layer decoder, and wherein performing one of the fractional decoding iterations comprises processing a subset of a plurality of columns in an H matrix for the non-layer decoder during the local decoding iteration; and/or
    the low density parity check decoder comprises a layer decoder, and wherein performing one of the fractional decoding iterations comprises processing a subset of a plurality of layers in an H matrix for the layer decoder during the local decoding iteration.

**14.** The method of any one of claims 11 to 13, wherein performing one of the fractional decoding iterations comprises generating check node to variable node messages in said one of the fractional decoding iterations based on a combination of new data generated in said one of the fractional decoding iterations and old data generated in one of the full decoding iterations.

**15.** A storage system comprising:

a storage medium maintaining a data set;
a read/write head assembly operable to sense the data set on the storage medium; and
an apparatus for processing the data set comprising:

a data detector operable to detect data values in the data set; and
a low density parity check decoder operable to iteratively perform a plurality of decoding iterations on the data set, wherein the plurality of decoding iterations comprises a selection of full decoding iterations and fractional decoding iterations to balance a decoder processing time with a detector processing time.

*FIG. 1 (Prior Art)*

C1 : a(1,1)V1 + a(1,4)V4 + a(1,6)V6 + a(1,7)V7 = 0

C2 : a(2,2)V2 + a(2,3)V3 + a(2,5)V5 + a(2,8)V8 = 0

C3 : a(3,1)V1 + a(3,3)V3 + a(3,5)V5 + a(3,6)V6 = 0

C4 : a(4,2)V2 + a(4,4)V4 + a(4,7)V7 + a(4,8)V8 = 0

*FIG. 2*

*FIG. 3A*

*FIG. 3B*

*FIG. 4*

*FIG. 5*

600

602

1st Local Iteration

610

604

2nd Local Iteration

606

Last Local Iteration

*FIG. 6A*

650

664

666

662

652

1st Local Iteration

660

654

2nd Local Iteration

656

Last Local Iteration

*FIG. 6B*

*FIG. 7*

800 —

Receive Data Sector
At Data Input
802

Is Data
Detector Available?
804
No
Yes

Select Data Sector To Be
Processed Next In Data
Detector, Either New Data
Sector From Data Input Or
Decoded Data Sector From
Data Decoder Output
806

Perform Data Detection
Algorithm On Selected Data
Sector
810

Determine Detector Processing
Time For Data Sector
812

Is Data
Decoder Available?
820
No
Yes

Select Data Sector From
Data Detector Output
To Be Decoded
822

Determine A Number Of Full
And Partial Local Decoding
Iterations To Be Performed In
Data Decoder To Reduce
Unused Processing Cycles In
Decoder While Preventing
Decoder Processing Time
From Exceeding Detector
Processing Time For
The Same Data Sector
824

Perform The Determined
Number Of Full And Partial
Local Decoding Iterations On
The Selected Data Sector In
The Data Decoder
826

Output Detected/Decoded Data
Sector If Data Converged Or If
Maximum Number Of Global
Iterations Performed, And
Purge The Data Sector From
The Detector/Decoder
Processing System To Provide
Room For A New Data
Sector From Data Input
830

FIG. 8

924

Write Data

Read Data

922

Interface Controller
906

Read Channel Including LDPC Decoder With Fractional Iterations
902

Preamp
904

920

Read/Write Head

900

Disk Platter
916

VCM

Hard Disk Controller
910

Motor Controller
912

Spindle Motor
914

*FIG. 9*

1000

Transmitter
1002

Transfer Medium
1006

Receiver Including LDPC Decoder With Fractional Iterations
1004

*FIG. 10*